# EUROPEAN PATENT APPLICATION

(11) **EP 3 432 063 A1**
(43) Date of publication of application: **23.01.2019**
(21) Application number: 17766781.3
(22) Date of filing: 16.03.2017
(51) Int. Cl.: G02F 1/1347, G02F 1/1334, G02F 1/1335, G09F 9/46

(54) **DISPLAY APPARATUS**

(30) Priority: 16.03.2016 JP 2016052699
(71) Applicant: Ortus Technology Co., Ltd., Tokyo 191-0065 (JP)
(72) Inventor: HIRAYAMA, Ryuichi, Hino-shi Tokyo 191-0065 (JP); IWANAMI, Norishige, Hino-shi Tokyo 191-0065 (JP)
(74) Representative: Nederlandsch Octrooibureau
(86) International application number: PCT/JP2017/010661
(87) International publication number: WO 2017/159785

(57) **Abstract**

A display device capable of preventing display property loss is provided.

An display device according to an aspect of the prevent invention includes a first display panel; a second display panel disposed above the first display panel with an air layer between the second display panel and the first display panel; and a light source unit disposed below the first display panel. The second display panel includes an anti-reflection film disposed on the air layer side surface.

## Description

### FIELD

The present invention relates to a display device.

### BACKGROUND

Display devices configured so that two kinds of display panels (e.g., liquid crystal display panels) having different functions regarding image display are overlapped make a more complex image display possible (see Japanese Patent No. 5640178). By providing a gap between the two liquid crystal display panels, the contrast is improved.

In a display device configured as described above, the display panel disposed in the back from the viewer' s perspective is visible via the display panel disposed in the front. The images displayed on the liquid crystal display panel disposed in the back therefore often had poor image quality whenever light was reflected in the bottom of the liquid crystal display panel disposed in the front.

### SUMMARY

The present invention is intended to provide a display device capable of preventing display property loss.

An display device according to an aspect of the prevent invention comprises a first display panel; a second display panel disposed above the first display panel with an air layer between the second display panel and the first display panel; and a light source unit disposed below the first display panel. The second display panel comprises an anti-reflection film disposed on the air layer side surface.

According to the present invention, a display device capable of preventing display property loss is provided.

### BRIEF DESCRIPTION OF THE DRAWINGS

FIG. 1 is a perspective view of a liquid crystal display unit according to a first embodiment.
FIG. 2A is a perspective view of a second liquid crystal display panel, a first liquid crystal display panel, and a backlight.
FIG. 2B is a perspective view of a second liquid crystal display panel, a first liquid crystal display panel, and a backlight.
FIG. 2C is a perspective view of a second liquid crystal display panel, a first liquid crystal display panel, and a backlight.
FIG. 3 is a cross-sectional view of a liquid crystal display device according to the first embodiment.
FIG. 4 is a cross-sectional view of a liquid crystal display device according to a second embodiment.

### DETAILED DESCRIPTION

Hereinafter, embodiments will be described with reference to the drawings. However, note that the drawings are schematic or conceptual, and that dimensions, ratios etc. in the drawings are not necessarily faithful. Further, relations in dimension and ratio of elements which are the same but shown in different figures may differ. Especially, the technical idea underlying the present invention will hereinafter be clarified by presenting examples of devices and methods, but not specified by shape, configuration, arrangement or the like of its constituents. Note further that elements having the same function and being configured in the same manner will hereinafter be denoted by the same reference numerals, and redundant explanations will only be provided if necessary.

### [1] First embodiment

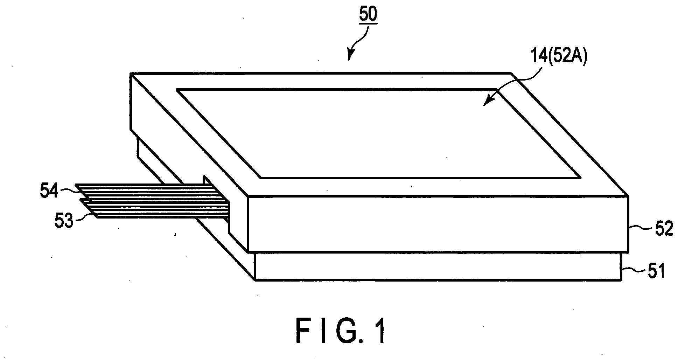

FIG. 1 is a perspective view of a liquid crystal display device 50 according to a first embodiment.

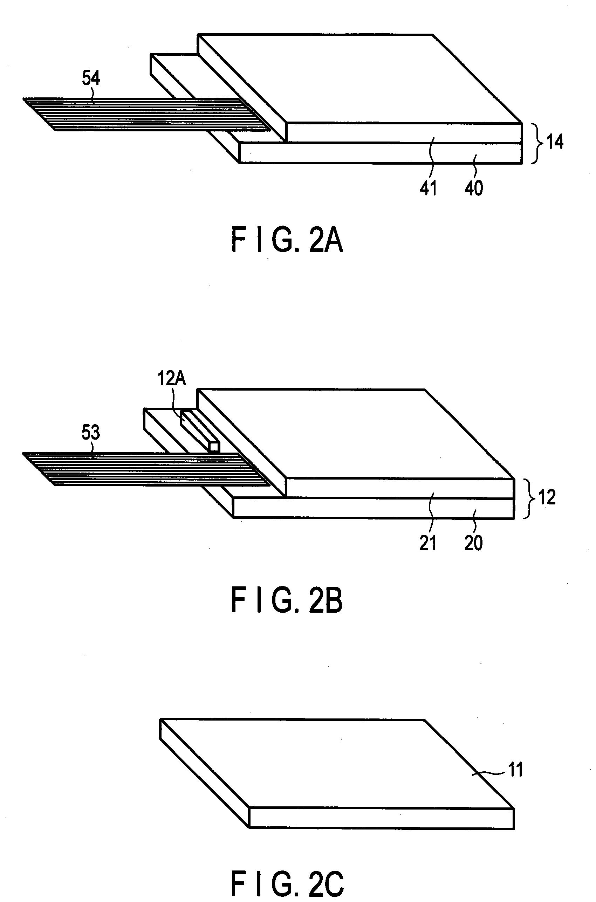

FIGS. 2A to 2C are perspective views of a second liquid crystal display panel, a first liquid crystal display panel, and a backlight.

The liquid crystal display device of the present embodiment includes a first liquid crystal display panel 12, a second liquid crystal display panel 14, a lower case 51, an upper case 52, and a backlight 11.

### (Lower case 51 and upper case 52)

The lower case 51 accommodates and supports, in the order of appearance, the backlight 11, the first liquid crystal display panel 12, and the second liquid crystal display panel 14. The upper case 52 covers the lower case 51 and is fixed to the lower case 51. The upper case 52 has an opening 52A through which a light passes for image display.

The external shape of the upper case 52 is slightly larger than that of the lower case 51. In other words, the internal size of the upper case 52 is approximately the same as the external size of the lower case 51. The top part of the upper case 52 has an opening 52A through which a light passes from the second liquid crystal display panel 14. The size of the opening 52A is set to be equal to or slightly larger than the display area of the second liquid crystal display panel 14. On one of the lateral surfaces of the upper case 52, an aperture is disposed to draw out a wiring portion connected to the first liquid crystal display panel 12 and a wiring portion connected to the second liquid crystal display panel 14. The lower case 51 may be made of, for example, a metal.

The external (planar) shape as viewed from above the lower case 51 is, for example, substantially quadrangular and has a size and depth capable of accommodating the backlight 11, the first liquid crystal display panel 12, and the second liquid crystal display panel 14. On one of the lateral surfaces of the lower case 51, an aperture is disposed for drawing out a wiring portion 53 connected to the first liquid crystal display panel 12 and a wiring portion 54 connected to the second liquid crystal display panel 14. The lower case 51 is made of, for example, a metal.

### (Backlight 11, first liquid crystal display panel 12, and second liquid crystal display panel 14)

FIG. 2A is a perspective view of the second liquid crystal display panel 14, FIG. 2B is a perspective view of the first liquid crystal display panel 12, and FIG. 2C is a perspective view of the backlight 11.

The wiring portion 54 is connected to the second liquid crystal display panel 14. The wiring portion 54 is constituted of, for example, a flexible printed circuit (FPC).

The wiring portion 53 is connected to the first liquid crystal display panel 12. The wiring portion 53 is constituted of, for example, the FPC. A driver 12A is disposed on the first liquid crystal display panel 12. By using various control signals and various voltages sent from outside, the driver 12A actuates pixels 24 (specifically, Thin Film Transistors 25, pixel electrodes 26, and a common electrode 29). The wiring portions 53 and 54 are connected to a power supply circuit, a control circuit and the like.

The backlight 11 shown in FIG. 2C in a simplified manner is constituted of a surface illuminant. The backlight 11 comprises, for example, a reflective sheet, a light guide plate, and a diffusion sheet that are laminated sequentially, and LEDs disposed as light source on the lateral surface of the laminate. The backlight 11 is disposed below the first liquid crystal display panel 12.

Next, an liquid crystal display unit 10 of the aforementioned liquid crystal display device 50 will be described. The liquid crystal display unit 10 is an liquid crystal display panel used in, for example, electronic wrist watches.

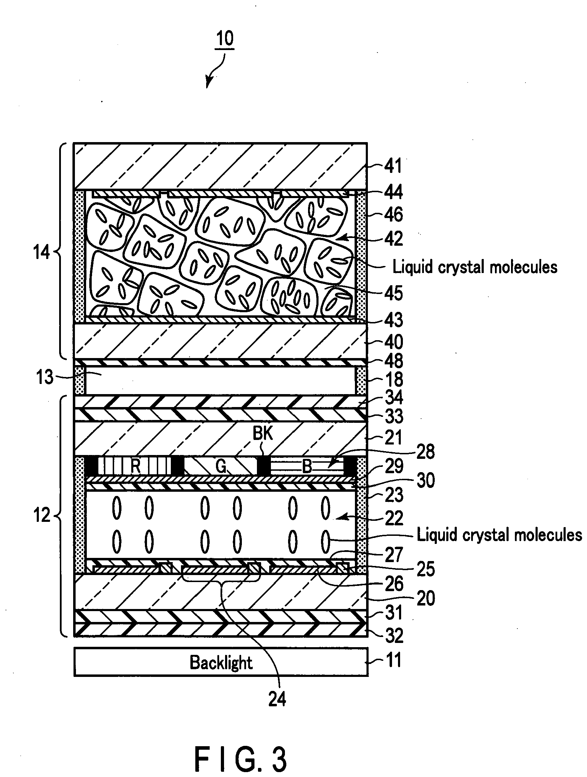

FIG. 3 is a cross-sectional view showing the liquid crystal display unit 10 in the liquid crystal display device 50 according to the first embodiment. The liquid crystal display unit 10 comprises the first liquid crystal display panel 12 and the second liquid crystal display panel 14. The first liquid crystal display panel 12 and the second liquid crystal display panel 14 are laminated to interpose a transparent member (e.g. , an air layer) 13a between them.

The first liquid crystal display panel 12 displays letters and images having a large amount of information (hereinafter referred to as information display) ; it can also display color. The first liquid crystal display panel 12 is constituted of a transmissive liquid crystal display panel having color filters. In other words, the first liquid crystal display panel 12 modulates light from the backlight 11 for displaying images.

The second liquid crystal display panel 14 is of the pattern display-type and displays letters and graphics having a small amount of information (hereinafter referred to as character display); it can also execute the transparent state display and the scattering state display, i.e. the monochrome display. The character display includes the display of characters and graphics having a small amount of information, the clock display (segment display) and the like. The second liquid crystal display panel 14 is constituted of, for example, an liquid crystal display panel selected from Polymer-Dispersed Liquid Crystals (PDLCs) or Polymer Network Liquid Crystals (PNLCs). The second liquid crystal display panel 14 does not use a polarization plate, and therefore is able to achieve a bright screen since the amount of light absorbed by the liquid crystal display panel itself is largely reduced. Furthermore, the second liquid crystal display panel 14 is visible in the bottom of the panel and can be driven with less power.

In this manner, according to the liquid crystal display unit 10 of the present embodiment, the second liquid crystal display panel 14 executes character display (including clock display and standby display) and the first liquid crystal display panel 12 executes information display for a larger amount of information than in the character display.

The first liquid crystal display panel 12 and the second liquid crystal display panel 14 are laminated to interpose a transparent member 13 between them. The transparent member 13 is in contact with an anti-reflection film 48 disposed below the second liquid crystal display panel 14, and the refraction index of the transparent member 13 is set to be different from the refraction index of the anti-reflection film 48. The transparent member 13 may be a transparent material satisfying the aforementioned conditions, and may be a gas or a liquid. According to the embodiment, the transparent member 13 is constituted of, for example, an air layer 13a. This air layer 13a is sealed between the first liquid crystal display panel 12 and the second liquid crystal display panel 14 by a spacer (or sealing material) 18. Note that the air layer 13a between the first liquid crystal display panel 12 and the second liquid crystal display panel 14 may or may not be sealed.

On the opposite side of the display surface of the liquid crystal display unit 10, a light source unit (backlight) 11 is disposed facing the display surface. The backlight 11 is, for example, a surface illuminant. As the backlight 11, for example, a back-lit or side-lit (edge-lit) LED backlight or an electroluminescent (EL) backlight may be used.

### (Configuration of the first liquid crystal display panel 12)

Next, the configuration of the first liquid crystal display panel 12 will be described. For the first liquid crystal display panel 12, for example, the active matrix method where an active element is disposed for each pixel is used.

The first liquid crystal display panel 12 comprises a TFT substrate 20 having TFTs (Thin Film Transistors) as active elements (switching elements) and pixel electrodes formed thereon; a color filter substrate (CF substrate) 21 which has color filters and a common electrode formed thereon and which is disposed in a position facing the TFT substrate 20; and a liquid crystal layer 22 interposed between the TFT substrate 20 and the CF substrate 21. The respective TFT substrate 20 and CF substrate 21 are constituted of a transparent substrate (e.g., a glass substrate).

The liquid crystal layer 22 is constituted of a liquid crystal material sealed by a sealing material 23 to bond the TFT substrate 20 and CF substrate 21. By manipulating the orientation of the liquid crystal molecules in the liquid crystal material by using an electric field to be applied between the TFT substrate 20 and the CF substrate 21, the optical characteristics are changed. For the first liquid crystal display panel 12 according to this embodiment, a VA-mode can be adopted which utilizes liquid crystals of the, for example, Vertical-Alignment (VA)-type. In other words, nematic liquid crystals of the negative type (N-type) are utilized as the liquid crystal layer 22, the liquid crystal molecules being oriented substantially orthogonal to the substrate surface in the case of voltage absence (electric field absence). The orientation of the liquid crystal molecules in the VA-mode is so that the long axes (directors) of the liquid crystal molecules are oriented vertically in the case of voltage absence, and is inclined in the horizontal direction in the case of voltage presence (electric field presence). Other liquid crystal modes applicable besides the VA-mode are the homogeneous mode or the Twisted Nematic (TN) mode. Note that the VA-mode is more suitable from the viewpoint of contrast improvement.

The TFTs 25 and the pixel electrodes 26 for the respective pixels 24 are disposed on the TFT substrate 20. To cover the TFTs 25 and the pixel electrodes 26, an orientation film 27 is disposed on the TFT substrate 20. Note that every display pixel consists of three sub-pixels having a red (R), green (G), and blue (B) color filter. Unless it is important to differentiate between display pixels and sub-pixels, sub pixels will hereinafter be referred to as pixels. The TFT 25s are formed on the liquid crystal layer 22 side of the TFT substrate 20; they are switching elements to turn the pixels 24 on and off.

A pixel electrode 26 is disposed for each pixel 24 almost throughout the corresponding region of the pixels 24. These pixel electrodes 26 are to apply voltage to the liquid crystal layer 22; they are electrically connected to one end of the current path of the TFT 25. The pixel electrode 26 is constituted of a transparent conductive film from, for example, indium tin oxide (ITO) . The orientation film 27 controls the orientation of the liquid crystal molecules.

Color filters 28, the common electrode 29, and an orientation film 30 are disposed on the CF substrate 21. The color filters 28 are disposed on the liquid crystal layer 22 side of the CF substrate 21 and comprise members in three colors for a red filter R, a green filter G, and a blue filter B. The red filter R, the green filter G, and the blue filter B are each disposed in a position facing the pixel electrodes 26; they constitute the sub pixels. A light-shielding film (black matrix) BK to prevent color mixing may be formed between the red filter R, the green filter G, and the blue filter B.

The common electrode 29 is disposed on the liquid crystal layer 22 side of the color filter 28, and it is formed into a flat-shaped surface over the entire display area. The common electrode 29 is made of a transparent conductive film from, for example, ITO. The orientation film 30 forms a pair with the orientation film 27 and controls the orientation of the liquid crystal molecules. According to the present embodiment, the orientation films 27 and 30 are formed to orient the liquid crystal molecules substantially orthogonal to the substrate surface without a substantial difference in potential between the pixel electrode 26 and the common electrode 29, that is, without an electric field applied between the pixel electrode 26 and the common electrode 29.

A retardation plate 31 and a polarization plate 32 are disposed on the backlight 11 side of the TFT substrate 20. A retardation plate 33 and a polarization plate 34 are disposed on the display surface side of the CF substrate 21. The polarization plates 32 and 34 are configured to extract, from a light having a plane of vibration in a random direction, a light having a plane of vibration in parallel direction to the transmission axes, that is, a light in the linearly polarized state. The polarization plates 32 and 34 are disposed so that the absorption axes and transmission axes are orthogonal to each other within the plane.

The retardation plates 31 and 33 are refraction-index anisotropic and disposed so that the lag axes and the advance axes are orthogonal to each other within the plane. A function of the retardation plates 31 and 33 is to apply a predetermined retardation (phase difference of λ/4, wherein λ is the wavelength of the passing light) between lights of a predetermined wavelength passing through each of the lag axes and advance axes. In other words, the retardation plates 31 and 33 are constituted of λ/4 plates . The lag axes of the retardation plates 31 and 33 are set at an angle of approximately 45° in relation to the transmission axes of the polarization plates 32 and 34.

Note that the angles defining the aforementioned polarization plates and retardation plates are assumed to include margins for achieving a desired action and margins attributable to the manufacturing process. For example, the aforementioned angle of approximately 45° is assumed to include a range of 45° ± 5°. As another example, the aforementioned orthogonal angle is assumed to include a range of 90° ± 5°.

### (Configuration of the second liquid crystal display panel 14)

Next, the configuration of the second liquid crystal display panel 14 will be described. The second liquid crystal display panel 14 comprises a lower substrate 40 on which the common electrode is formed, an upper substrate 41 on which the display electrode is formed and which is disposed in a position facing the lower substrate 40, and a liquid crystal layer 42 interposed between the lower substrate 40 and the upper substrate 41. The surface opposite to the liquid crystal layer 42 of the upper substrate 41 corresponds to the display surface of the liquid crystal display unit 10. The lower substrate 40 and the upper substrate 41 are each constituted of a transparent substrate (for example, a glass substrate).

A common electrode 43 is disposed on the lower substrate 40. The common electrode 43 is formed into a flat-shaped surface over the entire display area. The anti-reflection film 48 is disposed on the air layer 13a side of the lower substrate 40. A plurality of display electrodes 44 are disposed on the upper substrate 41. The plurality of display electrodes 44 are rendered into a shape corresponding to a character displayable by the second liquid crystal display panel 14. The common electrode 43 and the display electrode 44 are each constituted of a transparent conductive film from, for example, indium tin oxide (ITO).

The liquid crystal layer 42 is sealed with a sealing material 46 for bonding the lower substrate 40 to the upper substrate 41. As described above, the liquid crystal layer 42 is constituted of Polymer-dispersed Liquid Crystals (PDLCs) or Polymer Network Liquid Crystals (PNLCs) . The configuration of the PNLCs is so that the liquid crystal material is dispersed in a polymer network 45, and so that the liquid crystal material in the polymer network 45 has a continuous phase. The configuration of the PDLCs is so that the liquid crystals are dispersed by polymers, that is, the liquid crystals are phase-separated inside polymers. A photo-curable resin can be used as the polymer layer. To obtain PNLCs, ultraviolet rays are irradiated onto a solution containing the liquid crystal material mixed with a polymer precursor (monomers) of the photo-polymerized type to polymerize the monomers into polymers, and disperse the liquid crystal material in the network of polymers. Nematic liquid crystals of the positive type (P-type) are used as the liquid crystal material for the liquid crystal layer 42. In other words, in the case of voltage absence (electric field absence), the long axes (directors) of the liquid crystal molecules are oriented randomly, and in the case of voltage presence (electric field presence), the directors of the liquid crystal molecules are oriented approximately orthogonal to the substrate surface.

### (Effects of the first embodiment)

As described above in detail, the liquid crystal display device 50 according to the first embodiment comprises the second liquid crystal display panel 14 and the first liquid crystal display panel 12 having different display functions, the first liquid crystal display panel 12 and the second liquid crystal display panel 14 being laminated to interpose the air layer (space) 13a between them. The first liquid crystal display panel 12 and the second liquid crystal display panel 14 are laminated to interpose the air layer (space) 13a between them. The first liquid crystal display panel 12 and the second liquid crystal display panel 14 are housed in a case (constituted of a lower case 51 and an upper case 52). The case has the opening for drawing the wiring portion 53 connected to the first liquid crystal display panel 12 and the wiring portion 54 connected to the second liquid crystal display panel 14 to the outside.

Sometimes, when light entering from, for example, the second liquid crystal display panel 14 side of the liquid crystal display device 50 was reflected at the boundary between the lower substrate 40 of the second liquid crystal display panel 14 and the air layer 13a, the characters or images displayed at the first liquid crystal display panel 12 had poor image quality. The anti-reflection film 48 according to the present embodiment is therefore disposed on the air layer 13a side of the lower substrate 40 of the second liquid crystal display panel 14.

In the case where the anti-reflection film 48 was not disposed, i.e., in the case where the lower substrate 40 of the second liquid crystal display panel 14 and the air layer 13a were in contact, the transmittance of the light passing through the second liquid crystal display panel 14 was 82%. In contrast, in the case where the anti-reflection film 48 was disposed, the transmittance of the light passing through the second liquid crystal display panel 14 from the first liquid crystal display panel 12 side was 92%.

In this manner, according to the liquid crystal display device 50 of the present embodiment, the display properties of the display of the first liquid crystal display panel 12 can be improved and a display device capable of preventing display property loss can be provided.

### [2] Second embodiment

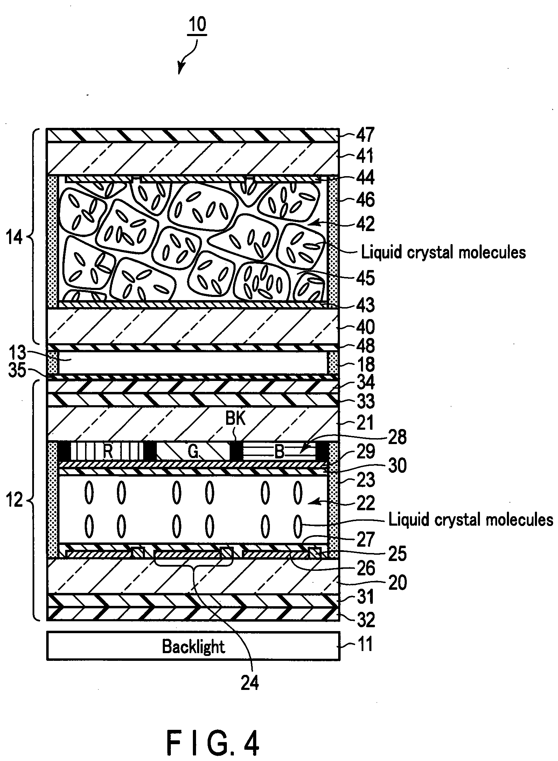

FIG. 4 is a cross-sectional view of the liquid crystal display unit 10 of the liquid crystal display device 50 according to a second embodiment. The configuration of the first liquid crystal display panel 12 and of the second liquid crystal display panel 14 in the liquid crystal display device 50 according to the embodiment are different from those according to the aforementioned first embodiment. Hereinafter, elements identical to those in the first embodiment will be denoted by the same reference numerals, and explanations of the same will be omitted.

According to the embodiment, the retardation plate 33, the polarization plate 34, and an Anti-Reflection (AR) layer 35 are disposed on the display surface side of the CF substrate 21 in the first liquid crystal display panel 12. In this embodiment, the surface of the polarization plate 34 on the air layer 13a side is flattened. The polarization plate 34 flattened so that the surface roughness of the surface on the air layer 13a side becomes equal to or less than a predetermined value may be used. Alternatively, a flattened film (not shown) may be formed on, for example, the surface on the air layer 13a side of the polarization plate 34 so that the surface roughness of the surface of the polarization plate 34 on the air layer 13a side becomes equal to or less than the predetermined value. The anti-reflection layer 35 is disposed between the flattened surface on the air layer 13a side of the first liquid crystal display panel 12 and the air layer 13a.

The anti-reflection layer 35 may be a film that is adhered and fixed to the flattened surface on the air layer 13a side of the polarization plate 34 and separate from the polarization plate 34, or may be a thin film formed by depositing a material on the flattened surface of the substrate. The anti-reflection layer 35 is a layer having, for example, a refraction index lower than the polarization plate 34.

Sometimes, in the case where the anti-reflection layer 35 was not disposed, the image quality was compromised due to light reflected at the boundary between the first liquid crystal display panel 12 and the air layer 13a. This light reflection at the boundary between the liquid crystal display panel 12 and the air layer 13a can be prevented by flattening the surface on the air layer 13a side of the first liquid crystal display panel 12 (surface on the air layer 13a side of the polarization plate 34) and disposing the anti-reflection layer 35 on the flattened surface. It is therefore possible to prevent image quality loss of the first liquid crystal display panel 12 by reflecting the light entering from the second display panel 14 side at the boundary between the air layer 13a and the first liquid crystal display panel 12.

Further disposed on the display surface side of the upper substrate 41 in the second liquid crystal display panel 14 is an ultraviolet (UV) cut film 47. When the liquid crystal display device 50 is mounted on, for example, an electronic wrist watch and the electronic wrist watch is used outdoors, external light enters from the display surface side of the upper substrate 41 of the second liquid crystal display panel 14. When the ultraviolet rays enter the liquid crystal layer 42 of the liquid crystal display device 50, the liquid crystal material deteriorates which causes image quality loss. In the present embodiment, the UV cut film 47 is therefore disposed on the display surface side of the upper substrate 41 in the second liquid crystal display panel 14 to prevent such quality loss in the liquid crystal layer 42.

In other words, according to the second embodiment, not only are the same effects achieved by the liquid crystal display device 50 as according to the aforementioned first embodiment, but also quality loss of the liquid crystal layer 42 due to ultraviolet rays is prevented, by which display property loss of the liquid crystal display device 50 is prevented.

As described above, the liquid crystal display device 50 according to the present embodiment can provide a display device capable of preventing display property loss.

Note that the liquid crystal display device 50 according to the second embodiment comprises both the anti-reflection film 48 disposed both on the lower substrate 40 of the second liquid crystal display panel 14 and on the air layer 13a side, and the anti-reflection film 35 disposed on the flattened surface on the air layer 13a side of the first liquid crystal display panel 12. However, since the liquid crystal display device 50 includes at least the anti-reflection film 48 or the anti-reflection layer 35, the first embodiment and the second embodiment achieve the same effects. Consequently, it is possible to omit either the anti-reflection film 48 or the anti-reflection layer 35 from the liquid crystal display device 50 according to this embodiment.

The present invention is not limited to the aforementioned embodiments, and the constituents of the present invention may be modified as long as the modifications do not deviate from the gist of the present invention. Moreover, the aforementioned embodiments include various stages of the invention, and various inventions may be configured by appropriately combining constituents of one embodiment or of different embodiments. For example, it is possible to extract an embodiment, wherein some of the constituents of all the constituents of the present embodiments are omitted, and still regard this embodiment as an embodiment according to the present invention, as long as the problem to be solved by the invention is solved and the effects to be achieved by the invention are achieved.

## Claims

1. A display device comprising:
a first display panel;
a second display panel disposed above the first display panel with an air layer between the second display panel and the first display panel; and
a light source unit disposed below the first display panel,
wherein the second display panel comprises an anti-reflection film disposed on the air layer side surface.

2. The display device according to claim 1, comprising an anti-reflection layer disposed between a flattened surface of the first display panel on the air layer side and the air layer.

3. The display device according to claim 1, wherein the second display panel further comprises a UV cut film disposed on the display surface side.

4. The display device according to claim 1, wherein the second display panel comprises a liquid crystal layer configured from a polymer-dispersed liquid crystal or a polymer network-type liquid crystal.

5. The display device according to claim 1, wherein the first display panel is a transmissive-type liquid crystal display panel.
